# FASCICULE DE BREVET EUROPEEN

(11) **EP 0 636 984 B1**
(45) Date de publication et mention de la délivrance du brevet: **02.10.1996**
(21) Numéro de dépôt: 94401364.8
(22) Date de dépôt: 17.06.1994
(51) Int. Cl.: G06F 11/16

(54) **Procédé et dispositif de contrôle des données dans un calculateur**
Verfahren und Vorrichtung zur Überwachung der Daten eines Rechners
Method and device for checking the data in a computer

(30) Priorité: 30.07.1993 FR 9309527
(43) Date de publication de la demande: 01.02.1995
(73) Titulaire: SEXTANT AVIONIQUE, F-92366 Meudon la Forêt Cédex (FR)
(72) Inventeur: Roussel, Pierre, F-92130 Issy Les Moulineaux (FR); Humez, Olivier, F-78140 Velizy (FR)
(74) Mandataire: de Saint-Palais, Arnaud Marie

(56) Documents cités:
- WO-A-89/11134
- US-A- 3 544 777
- US-A- 3 688 644
- PATENT ABSTRACTS OF JAPAN vol. 8, no. 228 (P-308)(1665) 19 Octobre 1984 & JP-A-59 107 495

## Description

La présente invention telle qu'elle est définie dans les revendications concerne un procédé et un dispositif de contrôle des données manipulées par un microprocesseur au sein d'un calculateur, et plus particulièrement des données qui sont stockées par le microprocesseur dans les mémoires vives appelées RAM du calculateur.

Elle s'applique notamment, mais non exclusivement, aux calculateurs numériques nécessitant une grande sécurité de fonctionnement, tel que, par exemple, les calculateurs embarqués utilisés dans l'avionique.

Or un calculateur numérique qui exécute un programme utilise des variables qu'il stocke soit dans les registres internes d'un microprocesseur, soit dans des mémoires de type RAM, pour les réutiliser plus tard, lors de calculs ultérieurs. Le problème qui se pose alors est de garantir l'intégrité de ces données.
En effet, entre le moment où une donnée est stockée et le moment où elle est relue pour une nouvelle utilisation dans un programme, il arrive que sa valeur soit modifiée du fait d'une défaillance.
Pour supprimer cet inconvénient, la plus simple des solutions consiste à stocker plusieurs fois les données dans des zones mémoire différentes. Lors de la relecture d'une donnée, il suffit alors de relire toutes les valeurs de la donnée qui ont été stockées et de les comparer entre elles. Si ces valeurs sont différentes, un système de vote majoritaire permet de déterminer quelle valeur peut être considérée comme bonne.
Les documents "Patent abstracts of Japan Vol.8 no. 228(P-308)(1665) 19 octobre 1984" et JP-A-59 107 495 divulguent un tel dispositif.
Si cette solution garantit une bonne sécurité, elle est très pénalisante du point de vue de la taille mémoire requise et du point de vue de la durée des accès à la mémoire, aussi bien en lecture qu'en écriture. En effet, pour pouvoir mettre en oeuvre un système de vote majoritaire, il faut au minimum tripler la taille de la mémoire normalement utilisée par le microprocesseur pour stocker les données. En ce qui concerne, le temps d'écriture d'une donnée, il est multiplié par autant de fois qu'une même donnée est écrite en mémoire. Il en est de même pour le temps de lecture d'une donnée, auquel il faut ajouter la durée du traitement de comparaison des valeurs lues, et éventuellement la détermination de la bonne valeur.

Une deuxième solution consiste à ajouter des bits de parité (1 bit de parité par octet par exemple). Ce bit de parité est calculé au moment du stockage de la donnée, et est ensuite stocké dans la zone mémoire en même temps que la donnée. Lors de la lecture de la donnée, les bits de parité sont recalculés et comparés avec ceux qui ont été stockés. Si une différence apparait, un signal est envoyé au processeur pour lui indiquer qu'une anomalie de stockage est apparue. Cette solution peut être améliorée en ajoutant à la donnée lors de son stockage, des codes correcteurs d'erreur permettant de corriger la valeur de la donnée, comme par exemple, les codes de Hamming.

Cette solution conduit également à augmenter de façon significative la taille de la mémoire de stockage des données nécessaire, et à augmenter les durées des lectures et écritures des données dans la mémoire. Par ailleurs, l'efficacité de détection d'une erreur est insuffisante et ne peut être améliorée qu'en augmentant la taille de la mémoire requise et en utilisant des traitements de lecture et d'écriture plus complexes.

Dans le but de supprimer ces inconvénients, la demanderesse a fait les constatations suivantes.
Un programme exécuté par un microprocesseur est généralement constitué d'un noyau appelant des procédures pour effectuer des traitements de données.
Ce programme manipule des variables de différents types, à savoir, les variables fournies aux procédures, dites d'entrée, les variables de sortie ou résultats fournis par les procédures, et les variables propres à la procédure en cours d'exécution.
Les variables d'entrée et de sortie sont généralement partagées par plusieurs procédures et peuvent donc être qualifiées de globales.

Par ailleurs, on peut constater que généralement, le nombre de variables globales pour chaque procédure est relativement faible (inférieur à 20 mots de 32 bits), et également, que la taille cumulée des variables locales d'une procédure n'excède pas 64 kilo-octets. Pour accroître la fiabilité de stockage de ces données de type globales, il suffit de tripler la zone mémoire affectée aux variables globales qui sont essentielles dans le déroulement d'un programme, et de leur appliquer une méthode de triple stockage.
En ce qui concerne les variables locales de chaque procédure, on peut se restreindre à une zone mémoire de 64 kilo-octets sur laquelle on applique également une méthode de triple stockage, et affecter dynamiquement cette zone mémoire aux données locales de la procédure en cours d'exécution.
Cette méthode permet d'une part de tripler virtuellement un grand espace mémoire en allouant dynamiquement une double copie de la zone mémoire en cours d'utilisation, et d'autre part, de récupérer une donnée bonne en cas de défaillance.
Cependant, cette méthode pénalise fortement le processeur qui doit effectuer trois écritures successives à des adresses différentes de la mémoire, ou bien lire trois fois de suite la même variable et vérifier que les trois valeurs lues sont identiques.
Cette méthode conduit donc à dégrader fortement la puissance de calcul du processeur, en triplant tous les accès à la mémoire.

L'invention a plus particulièrement pour but de supprimer ces inconvénients en proposant un procédé de contrôle des données manipulées par un calculateur comprenant un processeur connecté à des mémoires par un bus d'adressage, un bus de données et des lignes de transmission de signaux de contrôle, le processeur exécutant un programme composé de procédures, chacune des procédures en cours d'exécution utilisant notamment des variables qui leur sont propres et qui sont regroupées dans une première zone mémoire.

Ce procédé est caractérisé en ce qu'il comprend :
- la lecture par un automate externe au processeur, des signaux de contrôle, des données et des adresses transitant entre le processeur et la première zone mémoire,
- l'application par l'automate de ces signaux de contrôle à au moins deux autres zones mémoire,
- si ces signaux de contrôle correspondent à un ordre d'écriture en mémoire, l'écriture de la donnée lue sur le bus de données à l'adresse lue sur le bus d'adressage, simultanément dans les autres zones mémoire,
- si ces signaux de contrôle correspondent à un ordre de lecture, la lecture simultanée des données stockées respectivement dans les autres zones mémoire à l'adresse lue sur le bus d'adressage, la comparaison de ces données entre elles et avec la donnée lue sur le bus de données, et si toutes ces données ne sont pas identiques, l'envoi d'un signal d'interruption au processeur qui peut alors décider quelle donnée il doit prendre en compte.

Grâce à ces dispositions, le processeur est complètement déchargé des tâches de gestion du stockage multiple. Il suffit simplement de prévoir au niveau du processeur, une procédure qui sera exécutée lors de la réception du signal d'interruption et qui consiste à aller lire le résultat des comparaisons mémorisé dans un registre particulier accessible par le processeur, pour déterminer quelle est la donnée erronée, et donc quelle est la donnée à prendre en compte dans la suite du programme qui est en cours d'exécution. A cet effet, le processeur a accès aux autres zones mémoires.

Avantageusement, chaque case mémoire des deux secondes zones mémoires est associée à un bit de présence qui est placé à 1 lorsqu'une donnée est écrite dans cette case. Lorsqu'il vaut zéro, ce bit indique l'absence de donnée dans la case mémoire correspondante. Il est testé en même temps que la comparaison des données stockées dans les deux secondes zones mémoires. Le résultat du test de ce bit est mémorisé dans le même registre que celui contenant le résultat des trois comparaisons, et si le résultat de ce test indique que ce bit est à zéro, un signal d'interruption est envoyé au processeur. Cette disposition permet au processeur de détecter la lecture accidentelle d'une valeur non initialisée par lui-même dans une case mémoire.

Selon une particularité de l'invention, ce procédé comprend également l'initialisation par l'automate de toutes les cases mémoires des deux secondes zones mémoire, de leurs bits de présence associés, lors de l'activation d'une procédure.

Comme précédemment mentionné, l'invention concerne également un dispositif pour la mise en oeuvre du procédé, ce dispositif comprenant un automate et deux mémoires images d'une zone de la mémoire du calculateur, et dont la taille correspond à la taille cumulée maximum des données locales manipulées à un instant donné.

Cet automate comprend :
- un bloc de contrôle connecté aux lignes de transmission des signaux de contrôle entre le processeur et sa mémoire, et destiné à commander les autres organes de l'automate,
- deux bus de données internes reliés d'une part, respectivement aux deux mémoires images, et d'autre part, au bus de données du processeur par l'intermédiaire de respectivement deux passerelles tampons bidirectionnelles,
- un bus d'adressage interne relié d'une part, aux deux mémoires images, et d'autre part, au bus d'adressage du processeur par l'intermédiaire d'une passerelle tampon,
- trois comparateurs qui comparent, sur ordre du bloc de contrôle, respectivement les données présentes sur les bus internes entre elles et avec la donnée présente sur le bus de données du processeur, et qui inscrivent le résultat des comparaisons dans un registre d'état,
- deux blocs de forçage à 1 du bit de présence destinés à mettre à 1 le bit de présence associé respectivement aux données lors de leur écriture dans les mémoires images,
- deux testeurs de bit de présence qui, sur ordre du bloc de contrôle, testent respectivement les bits de présence associés aux deux données présentes respectivement sur les deux bus internes, et qui inscrivent le résultat des tests dans le registre d'état, et
- deux blocs de forçage à zéro associés à un générateur d'adresses et qui, sur ordre du bloc de contrôle, mettent à zéro respectivement toutes les données stockées dans les deux mémoires, ainsi que leur bit de présence associé.

Un mode de réalisation du dispositif selon l'invention sera décrit ci-après, à titre d'exemple non limitatif, avec référence aux dessins annexés dans lesquels :
La figure 1 représente schématiquement l'architecture d'un calculateur dans laquelle est intégré l'automate de contrôle des données ;
la figure 2 représente l'architecture de l'automate connecté aux deux mémoires.

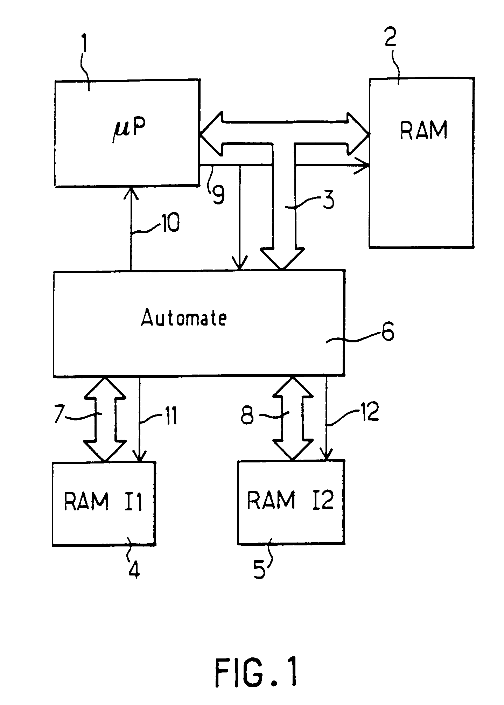

Le calculateur représenté sur la figure 1 comprend un microprocesseur 1 qui est relié à une mémoire volatile 2 de type RAM par l'intermédiaire de bus de données et d'adressage 3 et de lignes 9 de transmissions de signaux de contrôle. Il comprend également un automate 6 relié à la fois aux bus 3 et aux lignes de transmission 9. Cet automate est conçu pour contrôler deux mémoires volatiles 4,5 de type RAM, dont le contenu est l'image d'une partie de la mémoire 2, où sont stockées les données locales de la procédure en cours d'exécution, appelée par un noyau. Pour cela l'automate est connecté à ces deux mémoires images par l'intermédiaire de bus 7,8 de données et d'adressage, et de lignes de transmission de signaux de contrôle 11,12.
Ces deux mémoires ont chacune une capacité de, par exemple 64 kilo-octets qui suffit en général largement à contenir toutes les variables locales d'une procédure.

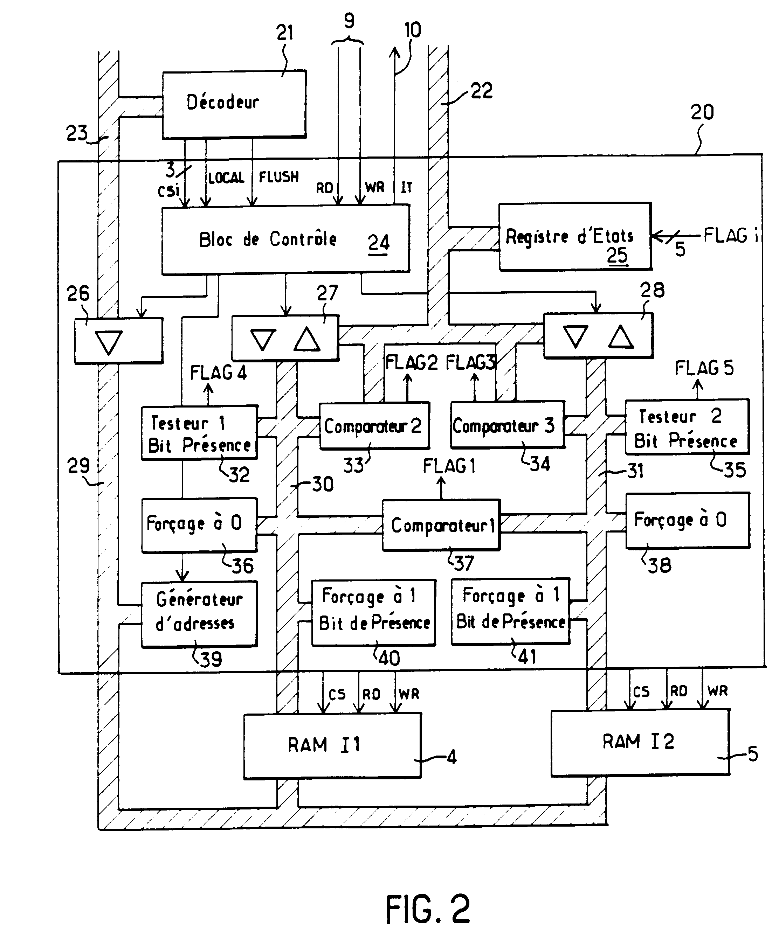

Sur la figure 2, l'automate comprend tout d'abord un décodeur permettant, à partir des valeurs présentes sur le bus d'adressage 23 du microprocesseur 1, de générer des signaux CS1, CS2, CS3, LOCAL, FLUSH de commande du bloc de contrôle 24.

Ce bloc de contrôle 24 reçoit par ailleurs du microprocesseur 1, les ordres de lecture RD et d'écriture WR en mémoire, et peut lui envoyer un signal IT d'interruption. Il contrôle notamment deux passerelles tampons bidirectionnelles 27,28 connectées au bus de données 22 du microprocesseur 1, et une passerelle tampon 26 reliée au bus d'adressage 23 du microprocesseur 1.

Les deux passerelles tampons bidirectionnelles 24,25 sont reliées par ailleurs, respectivement à deux bus de données internes 30,31, tandis que la passerelle tampon 26 est reliée à un bus d'adressage 29 permettant d'adresser toutes les cases mémoires des deux mémoires images 4,5. Ainsi, si par exemple les deux mémoires images font 64 kilo-octets chacune, seuls les 16 bits les moins significatifs du bus d'adressage 23 sont transmis au bus interne 29.

L'automate 6 comprend également trois comparateurs 37,33,34 contrôlés par le bloc de contrôle 24 et placés entre deux bus de données pour comparer entre elles les données transitant sur ces deux bus, à savoir :
- un premier comparateur 37 placé entre les deux bus de données internes 30,31,
- un second 33 et un troisième comparateur 34 placés entre le bus de données 22 du microprocesseur 1 et respectivement, les deux bus de données internes 30,31 de l'automate 6.

Ces trois comparateurs 37,33,34 sont déclenchés simultanément par le bloc de contrôle 24, et fournissent un résultat, respectivement FLAG1, FLAG2, FLAG3, qui est stocké dans un registre d'états 25.

L'automate comprend également deux blocs 40,41 de forçage du bit de présence à 1 connectés respectivement aux bus de données internes 30,31, et destinés à mettre à 1 les bits de présence des données qui sont en cours d'écriture dans les mémoires images 4,5.

Deux testeurs du bit de présence 32,35 sont respectivement connectés aux bus de données internes 30,31, pour tester un bit qui est associé à chaque case mémoire des mémoires images respectives 4,5. Ce bit permet de différentier les cases mémoires dans lesquelles des données ont été stockées, des cases mémoires encore vierges.
Ces testeurs de bit de présence 32,35 fournissent sur ordre du bloc de contrôle 24 un résultat, respectivement FLAG4 et FLAG5, qui est également inscrit dans le registre d'états 25.

Le bloc de contrôle 24 est conçu de manière à être capable de répondre aux ordres suivants provenant du microprocesseur 1 :
- une triple écriture d'une donnée locale en mémoire (WR et LOCAL actifs),
- une triple lecture d'une donnée locale en mémoire (RD et LOCAL actifs),
- une initialisation des mémoires images 4,5 (FLUSH actif),
- la lecture du contenu du registre d'états (CS3 actif), et
- la lecture de la donnée située à l'adresse présente sur le bus d'adressage interne 29, dans l'une des deux mémoires images 4,5 (CS1 ou CS2 actif, suivant la mémoire image 4 ou 5 à laquelle on veut accéder).

Lorsque le bloc de contrôle 24 reçoit un ordre de triple écriture, les passerelles tampons bidirectionnelles 27,28 sont activées de manière à transférer la donnée présente sur le bus externe 22, simultanément vers les deux bus internes 30,31. La passerelle tampon 26 est également activée pour transférer les 16 bits les moins significatifs de l'adresse présente sur le bus d'adressage 23 vers le bus d'adressage interne 29. Par ailleurs, le bloc de contrôle 24 envoie un signal d'écriture WR aux deux mémoires images 4,5.
Ces opérations permettent de mémoriser la donnée que le microprocesseur 1 est en train de stocker dans sa mémoire RAM 2, simultanément dans les deux mémoires images 4,5, à l'adresse fournie par les 16 bits les moins significatifs de l'adresse émise par le microprocesseur 1 sur son bus d'adressage 23. Au cours de cette opération, le bit de présence associé à cette donnée est placé à 1 dans les mémoires images 4,5.

Lorsque le microprocesseur 1 effectue la lecture d'une donnée locale à une procédure dans sa mémoire RAM 2, le bloc de contrôle 24 reçoit simultanément un ordre de triple lecture. A cet instant, il vérifie tout d'abord qu'aucun des signaux CS1,CS2,CS3 n'est actif, et active la passerelle tampon 26 pour transférer l'adresse présente sur le bus d'adressage externe 23 vers le bus d'adressage interne 29. Ensuite, il commande la lecture simultanée des deux mémoires images 4,5 à l'adresse située sur le bus d'adressage interne 29, en leur envoyant un signal de lecture RD. Cette opération permet de déclencher l'écriture des données présentes dans les deux mémoires images 4,5, à l'adresse fournie par le bus d'adressage interne 29, sur les deux bus de données internes 30,31.

A partir de cet instant, le bloc de contrôle 24 déclenche simultanément les trois comparateurs 33,34,37 et les deux testeurs de bit de présence 32,35 qui vont mettre à jour le registre d'états, et envoyer un signal d'interruption IT au microprocesseur 1, si une anomalie est détectée (détection d'une différence entre les données lues ou un bit de présence à zéro). Il faut noter que pendant la lecture des mémoires images 4,5, le microprocesseur 1 est en train de lire sa mémoire 2, et donc la donnée qu'il est en train de lire est présente sur le bus de données externe 22.
Dans le cas où aucune anomalie n'est constatée, le microprocesseur 1 ne reçoit aucun signal de l'automate 6 et, vu du microprocesseur 1, tout se passe comme s'il l'on effectuait une lecture simple.
Dans le cas contraire, le microprocesseur 1 peut aller consulter le registre d'états 25 pour déterminer quelles sont la ou les données valides, et peut accéder au contenu des mémoires images 4,5 à l'adresse de la donnée qu'il veut lire.
A cet effet, lorsque le bloc de contrôle 24 reçoit le signal CS3, il déclenche le transfert du contenu du registre d'état sur le bus de données externe 22.
Lorsque le bloc de contrôle 24 reçoit l'un des signaux CS1 ou CS2, il active la passerelle tampon 26, et l'une des deux passerelles tampons bidirectionnelles 27,28, suivant que le signal CS1 ou CS2 est actif, de manière à transférer l'adresse présente sur le bus externe 23 vers le bus interne 29, et la donnée qui sera présente sur l'un des deux bus internes 30,31, vers le bus de données externe 22. Simultanément, il envoie un ordre de lecture RD de la mémoire image 4 ou 5 correspondant au signal CS1 ou CS2 actif, ce qui provoque l'écriture sur le bus interne 30 ou 31 de la donnée présente à l'adresse fournie par le bus d'adressage interne 29.

Lors du passage d'une procédure à une autre, il est nécessaire d'initialiser les deux mémoires images 4,5. Pour cela l'automate met à la disposition de son environnement la commande FLUSH qui active des blocs de forçage à zéro 36,38, ainsi qu'un générateur d'adresses 39, de manière à parcourir toutes les cases mémoire des mémoires images 4,5 et à forcer ces dernières à zéro, ainsi que leur bit de présence associés.

L'automate 6 peut être réalisé à l'aide d'un seul composant électronique de type ASIC (Application Specific Integrated Circuit) qui intègre tous ses éléments.

Ce dispositif est particulièrement adapté aux processeurs de la famille 286/386/486 fabriqués par la société INTEL qui présentent un mode de fonctionnement protégé en segmentant leur espace mémoire adressable en segments de 64 kilo-octets par exemple. Ainsi, pour exécuter un programme, un segment mémoire est réservé au code du programme, quatre segments aux données, et un segment à la pile. Selon cette disposition, un des quatre segments de données peut être attribué aux données locales, et les autres aux données globales.
Pour augmenter encore la sécurité, il est également possible de définir un segment de pile commun à toutes les procédures et de lui associer un autre dispositif de contrôle des données tel que décrit précédemment.

## Revendications

1. Procédé de contrôle des données manipulées par un calculateur comprenant un processeur (1) connecté à des mémoires (2) par un bus d'adressage (23), un bus de données (22) et des lignes de transmission de signaux de contrôle (9), le processeur (1) exécutant un programme composé de procédures, chacune des procédures en cours d'exécution utilisant notamment des variables qui leur sont propres et qui sont regroupées dans une première zone mémoire,
caractérisé en ce qu'il comprend lors de l'éxécution d'une procédure :
- la lecture par un automate (6) externe au processeur (1), des signaux de contrôle, des données et des adresses propres aux données utilisées spécifiquement par la procédure transitant entre le processeur (1) et la première zone mémoire,
- l'application par l'automate de ces signaux de contrôle à au moins deux autres zones mémoire (4,5),
- si ces signaux de contrôle correspondent à un ordre d'écriture en mémoire, l'écriture de la donnée lue sur le bus de données (22) à l'adresse lue sur le bus d'adressage (23), simultanément dans les autres zones mémoire (4,5),
- si ces signaux de contrôle correspondent à un ordre de lecture, la lecture simultanée des données stockées respectivement dans les autres zones mémoire (4,5) à l'adresse lue sur le bus d'adressage (23), la comparaison de ces données entre elles et avec la donnée lue sur le bus de données (22), et si toutes ces données ne sont pas identiques, l'envoi d'un signal d'interruption au processeur (1) qui peut alors décider quelle donnée il doit prendre en compte.

2. Procédé selon la revendication 1,
caractérisé en ce qu'il comprend, lors du stockage d'une donnée dans chacune des autres zones mémoire (4,5), le stockage dans ces dernières d'un bit de présence positionné à l'état logique 1, associé à cette donnée.

3. Procédé selon la revendication 2,
caractérisé en ce qu'il comprend l'effacement de toutes les données stockées dans les autres zones mémoires (4,5) et la remise à zéro de tous les bits de présence associés, lors de l'activation d'une procédure par le processeur (1).

4. Dispositif pour la mise en oeuvre du procédé selon l'une des revendications précédentes,
caractérisé en ce qu'il comprend un automate (6) et deux mémoires (4,5) images d'une zone de la mémoire du calculateur (2), et dont la taille correspond à la taille cumulée maximum des données locales manipulées à un instant donné, l'automate (6) comprenant :
- un bloc de contrôle (24) connecté aux lignes de transmission des signaux de contrôle (RD,WR) entre le processeur (1) et sa mémoire (2), et destiné à commander les autres organes de l'automate (6),
- deux bus de données internes (30,31) reliés d'une part, respectivement aux mémoires images (4,5), et d'autre part, au bus de données (22) du processeur (1) par l'intermédiaire de respectivement de deux passerelles tampons bidirectionnelles (27,28),
- un bus d'adressage interne (29) relié d'une part, aux deux mémoires images (4,5), et d'autre part, au bus d'adressage (23) du processeur (1) par l'intermédiaire d'une passerelle tampon (26), et
- trois comparateurs (37,33,34) qui comparent, sur ordre du bloc de contrôle, respectivement les données présentes sur les bus internes (30,31) entre elles et avec la donnée présente sur le bus de données (22) du processeur (1), et qui inscrivent le résultat des comparaisons dans un registre d'états (25), et
- des moyens pour générer un signal d'interruption (IT) à destination du processeur (1), lorsque le registre d'états (25) indique qu'une erreur a été détectée.

5. Dispositif selon la revendication 4,
caractérisé en ce que l'automate (6) comprend :
- deux blocs de forçage à 1 du bit de présence (40,41) destinés à mettre à 1 le bit de présence associé respectivement aux données lors de leur écriture dans les mémoires images (4,5), et
- deux testeurs de bit de présence (32,35) qui, sur ordre du bloc de contrôle (24), testent respectivement les bits de présence associés aux deux données présentes respectivement sur les deux bus de données internes (30,31), et qui inscrivent le résultat des tests dans le registre d'états (25).

6. Dispositif selon l'une des revendications 4 et 5 ,
caractérisé en ce que l'automate (6) comprend deux organes de forçage à zéro (36,38) associés à un générateur d'adresses (39) capable de parcourir toutes les adresses des mémoires images (4,5), qui, sur ordre du bloc de contrôle (24), mettent à zéro respectivement toutes les données stockées dans les deux mémoires images (4,5), ainsi que leur bit de présence associé.

7. Dispositif selon l'une des revendications 4 à 6,
caractérisé en ce qu'il comprend un décodeur (21) connecté au bus d'adressage (23) du processeur (1) capable de générer les signaux suivants destinés au bloc de contrôle (24) de l'automate (1) :
- un signal (LOCAL) indiquant que le processeur (1) a déclenché une lecture ou une écriture d'une donnée locale à la procédure en cours d'exécution,
- un signal (FLUSH) de déclenchement de l'effacement des données et de leur bit de présence associé, stockés dans les deux mémoires images (4,5),
- un signal (CS3) de lecture du registre d'états, et
- deux signaux (CS1, CS2) de lecture de la donnée stockée à l'adresse présente sur le bus d'adressage interne (23), respectivement dans les deux mémoires images (4,5).

8. Dispositif selon l'une des revendications 4 à 7,
caractérisé en ce que l'automate (6), à l'exception du décodeur (21), est réalisé à l'aide d'un seul composant électronique (20) de type ASIC.

## Patentansprüche

1. Verfahren zur Steuerung von Daten, die von einem Rechner manipuliert werden, der einen Prozessor (1) aufweist, der über einen Adressierbus (23), einen Datenbus (22) und Übertragungsleitungen (9) für Steuersignale mit Speichern (2) verbunden ist, wobei der Prozessor (1) ein Programm ausführt, das aus Prozeduren besteht, wobei jede der durchgeführten Prozeduren insbesondere Variablen verwendet, die ihr eigen sind und die in einer ersten Speicherzone gruppiert angeordnet sind,
dadurch gekennzeichnet, daß es bei der Durchführung einer Prozedur aufweist:
- das Lesen der Steuersignale, der Daten und der den Daten eigenen, spezifisch von der Prozedur verwendeten Adressen, die zwischen dem Prozessor (1) und der ersten Speicherzone übertragen werden, durch einen außerhalb des Prozessors (1) angeordneten Automaten (6),
- das Anlegen dieser Steuersignale durch den Automaten an mindestens zwei weitere Speicherzonen (4, 5),
- wenn diese Steuersignale einem Speicher-Einschreibbefehl entsprechen, das Einschreiben der auf dem Datenbus (22) gelesenen Dateneinheit an der auf dem Adressierbus (23) gelesenen Adresse gleichzeitig in den anderen Speicherzonen (4, 5),
- wenn diese Steuersignale einem Lesebefehl entsprechen, das gleichzeitige Lesen der Daten, die in den anderen Speicherzonen (4, 5) an der auf dem Adressierbus (23) gelesenen Adresse gespeichert sind, der Vergleich dieser Daten miteinander und mit der auf dem Datenbus (22) gelesenen Dateneinheit, und wenn alle diese Daten nicht identisch sind, das Senden eines Unterbrechungssignals an den Prozessor (1), der dann entscheidet, welche Dateneinheit er berücksichtigen muß.

2. Verfahren nach Anspruch 1, dadurch gekennzeichnet, daß es beim Speichern einer Dateneinheit in jede der anderen Speicherzonen (4, 5) das Speichern eines Präsenzbits im logischen Zustand 1, das dieser Dateneinheit zugeordnet ist, in diese Speicherzonen enthält.

3. Verfahren nach Anspruch 2, dadurch gekennzeichnet, daß es das Löschen aller in den anderen Speicherzonen (4, 5) enthaltenen Daten und die Nullrückstellung aller zugeordneten Präsenzbits bei der Aktivierung einer Prozedur durch den Prozessor (1) enthält.

4. Vorrichtung zur Anwendung des Verfahrens nach einem der vorhergehenden Ansprüche, dadurch gekennzeichnet, daß sie einen Automaten (6) und zwei Speicher (4, 5) aufweist, die ein Bild einer Zone des Speichers des Rechners (2) sind und deren Größe der maximalen kumulierten Größe der zu einem gegebenen Zeitpunkt manipulierten lokalen Daten entspricht, wobei der Automat (6) aufweist:
- einen Steuerblock (24), der mit den Übertragungsleitungen der Steuersignale (RD, WR) zwischen dem Prozessor (1) und seinem Speicher (2) verbunden ist und der die anderen Organe des Automaten (6) steuert,
- zwei innere Datenbusleitungen (30, 31), die einerseits mit den Bildspeichern (4, 5) und andererseits mit dem Datenbus (22) des Prozessors (1) über zwei bidirektionale Pufferbrücken (27, 28) verbunden sind,
- einen inneren Adressierbus (29), der einerseits mit den beiden Bildspeichern (4, 5) und andererseits mit dem Adressierbus (23) des Prozessors (1) über eine Pufferbrücke (26) verbunden ist, und
- drei Komparatoren (37, 33, 34), die auf Befehl des Steuerblocks die auf den inneren Busleitungen (30, 31) vorhandenen Daten miteinander und mit der auf dem Datenbus (22) des Prozessors (1) vorhandenen Dateneinheit vergleichen und die das Ergebnis des Vergleichs in ein Zustandsregister (25) eintragen, und
- Mittel, um ein Unterbrechungssignal (IT) für den Prozessor (1) zu erzeugen, wenn das Zustandsregister (25) angibt, daß ein Fehler erfaßt wurde.

5. Vorrichtung nach Anspruch 4, dadurch gekennzeichnet, daß der Automat (6) aufweist:
- zwei Blöcke (40, 41) zum Zwingen des Präsenzbits auf 1, die das Präsenzbit, das den Daten bei ihrem Einschreiben in die Bildspeicher (4, 5) zugeordnet ist, auf 1 zwingen sollen,
- zwei Präsenzbit-Testorgane (32, 35), die auf Befehl des Steuerblocks (24) die Präsenzbits testen, die den auf den beiden inneren Datenbusleitungen (30, 31) vorhandenen beiden Dateneinheiten zugeordnet sind und die das Ergebnis der Tests in das Zustandsregister (25) eintragen.

6. Vorrichtung nach einem der Ansprüche 4 und 5, dadurch gekennzeichnet, daß der Automat (6) zwei Organe zum auf Null setzen (36, 38) aufweist, die einem Adressengenerator (39) zugeordnet sind, der alle Adressen der Bildspeicher (4, 5) durchlaufen kann, die auf Befehl des Steuerblocks (24) alle in den beiden Bildspeichern (4, 5) gespeicherten Daten sowie ihr zugeordnetes Präsenzbit auf Null setzen.

7. Vorrichtung nach einem der Ansprüche 4 bis 6, dadurch gekennzeichnet, daß sie einen Dekodierer (21) aufweist, der mit dem Adressierbus (23) des Prozessors (1) verbunden ist und die folgenden Signale erzeugen kann, die für den Steuerblock (24) des Automaten (6) bestimmt sind:
- ein Signal (LOCAL), das angibt, daß der Prozessor (1) einen Lese- oder einen Schreibvorgang einer lokalen Dateneinheit der in Durchführung befindlichen Prozedur ausgelöst hat,
- ein Signal (FLUSH) zum Auslösen der Löschung der Daten und ihres zugehörigen Präsenzbits, die in den beiden Bildspeichern (4, 5) gespeichert sind,
- ein Signal (CS3) zum Lesen des Zustandsregisters und
- zwei Signale (CS1, CS2) zum Lesen der gespeicherten Dateneinheit an der auf dem inneren Adressierbus (23) vorhandenen Adresse bzw. in den beiden Bildspeichern (4, 5).

8. Vorrichtung nach einem der Ansprüche 4 bis 7, dadurch gekennzeichnet, daß der Automat (6) mit Ausnahme des Dekodierers (1) mit Hilfe eines einzigen Elektronikbauteils (20) vom Typ ASIC hergestellt wird.

## Claims

1. Method for controlling data manipulated by a computer comprising a processor (1) connected to memories (2) via an addressing bus (23), a data bus (22) and control signal transmission lines (9), the processor (1) executing a programme comprised of procedures, each of the procedures being executed notably using variables specific to it and which are grouped together in a first memory zone,
characterized in that it comprises, upon execution of a procedure:
- the reading by an automaton (6) outside of the processor (1), of the control signals, data and addresses specific to the data used specifically by the procedure in transit between the processor (1) and the first memory zone,
- the application, by the automaton, of these control signals to at least two other memory zones (4, 5),
- if these control signals correspond to a memory write command, the writing of the datum read on the data bus (22), at the address read on the addressing bus (23), simultaneously in the other memory zones (4, 5),
- if these control signals correspond to a read command, the simultaneous reading of the data stored respectively in the other memory zones (4, 5) at the address read on the addressing bus (23), the comparison of these data with one another and with the datum read on the data bus (22), and if all these data are not identical, the transmission of an interrupt signal to the processor (1) which can then decide which datum it should take into account.

2. Method as claimed in claim 1,
characterized in that it comprises, upon storage of a datum in each of the other memory zones (4, 5), storage in the latter of a presence bit positioned in the logic "1" state, associated with said datum.

3. Method as claimed in claim 2,
characterized in that it comprises the erasing of all the data stored in the other memory zones (4, 5), and the zeroizing of all the associated presence bits, upon activation of a procedure by the processor (1).

4. Device for implementing the method as claimed in any one of the previous claims,
characterized in that it comprises an automaton (6) and two image spaces (4, 5) of a zone of the memory of the computer (2) and of which the size corresponds to the maximum cumulative size of the local data manipulated at a given moment, the automaton comprising:
- a control block (24) connected to the control signal (RD, WR) transmission lines between the processor (1) and its memory (2), and intended to command the other devices of the automaton (6),
- two internal data buses (30, 31) connected, on the one hand, respectively to the image spaces (4, 5), and, on the other hand, to the data bus (22) of the processor (1) respectively via two bidirectional buffer gateways (27, 28),
- one internal addressing bus (29) connected, on the one hand, to the two image spaces (4, 5), and, on the other hand, to the addressing bus (23) of the processor (1) via a buffer gateway (26), and
- three comparators (37, 33, 34) which, when commanded by the control block, respectively compare the data present on the internal buses with one another as well as with the datum present on the data bus (22) of the processor (1), and which inscribe the result of these comparisons in a status register (25), and
- a means for generating an interrupt signal (IT) addressed to the processor (1) when the status register (25) indicates that an error has been detected.

5. Device as claimed in claim 4,
characterized in that the automaton (6) comprises:
- two blocks (40, 41) for presetting the presence bit to "1", intended to set to "1" the presence bit respectively associated with the data when they are written in the image spaces (4, 5), and
- two presence bit testers (32, 35) which, when commanded by the control block (24), respectively test the presence bits associated with the two data respectively present on the two internal data buses (30, 31), and which inscribe the result of the tests in the status register (25).

6. Device as claimed in claim 4 or 5,
characterized in that the automaton (6) comprises two devices for presetting to "0" (36, 38) associated with an address generator (39) capable of browsing through all the addresses in the image spaces (4, 5) which, when commanded by the control block (24), respectively set to "0" all the data stored in the two image spaces (4, 5), as well as the presence bit associated therewith.

7. Device as claimed in any one of claims 4 to 6, characterized in that it comprises a decoder (21) connected to the addressing bus (23) of the processor (1) capable of generating the following signals intended for the control block (24) of the automaton (1):
- a signal (LOCAL) indicating that the processor (1) has triggered a read or write operation on a datum local to the procedure being executed,
- a signal (FLUSH) triggering an erasing of the data and associated presence bit stored in the two image spaces (4, 5),
- a signal (CS3) indicating reading of the status register, and
- two signals (CS1, CS2) indicating reading of the data stored at the address present on the internal addressing bus (23), respectively in the two image spaces (4, 5).

8. Device as claimed in any one of claims 4 to 7, characterized in that the automaton (6), with the exception of the decoder (21), is manufactured by means of one single ASIC type electronic component (20).
